Europäisches Patentamt

European Patent Office

Office européen des brevets

(19)

(11) Numéro de publication : **0 468 857 A1**

# (12) DEMANDE DE BREVET EUROPEEN

(21) Numéro de dépôt : **91401993.0**

(22) Date de dépôt : **17.07.91**

(51) Int. Cl.$^5$ : **G01R 33/36**

(30) Priorité : **25.07.90 FR 9009534**

(43) Date de publication de la demande :
**29.01.92 Bulletin 92/05**

(84) Etats contractants désignés :
**AT BE CH DE DK ES FR GB GR IT LI LU NL SE**

(71) Demandeur : **MAGNETECH S.A.**
**21, rue de Bois de la Champelle**
**F-54503 Vandoeuvre-les-Nancy Cédex (FR)**

(72) Inventeur : **Darrasse, Luc**
**14, rue d'Aligre**
**F-75012 Paris (FR)**
Inventeur : **Raad, Ahmad**
**Résidence AFI, 3, Allée de Madrid**
**F-91300 Massy (FR)**

(74) Mandataire : **Casalonga, Axel et al**
**BUREAU D.A. CASALONGA - JOSSE**
**Morassistrasse 8**
**W-8000 München 5 (DE)**

(54) **Dispositif de réception sans fil pour appareils d'imagerie par résonance magnétique nucléaire.**

(57)    Dispositif de réception de signaux électromagnétiques, notamment de signaux émis par un volume examiné d'un sujet selon la technique de résonance magnétique nucléaire, comprenant une antenne de réception (1) placée au voisinage du volume examiné, une antenne de couplage (4) couplée par induction à l'antenne de réception et un amplificateur (7) à haute impédance d'entrée dont les bornes d'entrée sont reliées aux bornes d'une capacité de sortie (Cs) de l'antenne de couplage (4) et dont la sortie est reliée à une unité de traitement du signal en vue d'obtenir une image du volume examiné. Le coefficient de couplage magnétique (k) entre l'antenne de réception et l'antenne de couplage est supérieur au coefficient de couplage critique (kc) défini par les facteurs de qualité respectifs desdites antennes.

FIG.4

EP 0 468 857 A1

La présente invention concerne un dispositif de réception de signaux électromagnétiques, notamment de signaux émis par un volume examiné d'un sujet selon la technique de résonance magnétique nucléaire, comprenant une antenne de réception placée au voisinage du volume examiné et une antenne de couplage reliée à une unité de traitement du signal, la liaison entre l'antenne de réception et l'antenne de couplage étant du type sans fil par couplage inductif.

La technique de l'imagerie par résonance magnétique nucléaire consiste schématiquement à soumettre un sujet à un champ magnétique, à capter des signaux émis par un volume examiné du sujet dans le champ magnétique et à traiter les signaux captés pour reconstituer une image caractéristique du volume examiné du sujet. Le sujet peut être un être vivant ou un corps à l'état solide ou liquide.

Le champ magnétique dans lequel est placé le sujet comprend un champ magnétique homogène dit "principal" et un champ magnétique radiofréquence dit "d'excitation". Le champ principal est obtenu à l'aide d'un générateur de champ magnétique, constitué par exemple par des aimants permanents ou par des bobines magnétiques supraconductrices ou résistives. Le champ d'excitation est appliqué par exemple par impulsions pendant l'examen du sujet.

Sous l'action combinée du champ principal et du champ d'excitation, certains noyaux atomiques se trouvant à l'intérieur du volume examiné du sujet émettent un signal de champ magnétique extrêmement faible dans la bande radiofréquence. Ce signal est détecté à l'aide d'une antenne de réception placée au voisinage immédiat du volume examiné et est transformé en un signal électrique correspondant qui est envoyé à une unité de traitement du signal dit "récepteur".

La qualité de l'image obtenue du volume examiné dépend, dans une large mesure, de la conception et de la mise en oeuvre de l'ensemble qui assure la détection du signal de champ magnétique émis par le volume examiné, et la transformation du signal capté en signal électrique correspondant à l'entrée du récepteur.

Actuellement, sur la plupart des appareils d'imagerie par résonance magnétique nucléaire, appelés également imageurs, la sortie de l'antenne de réception est reliée à l'entrée du récepteur au moyen d'un câble électrique coaxial souple constituant une ligne de transmission blindée que l'opérateur doit connecter au moment de la mise en place de l'antenne de réception lors de l'examen du sujet. Une telle liaison, dite liaison directe par câble, entre l'antenne de réception et le récepteur implique : une manipulation supplémentaire pour l'opérateur, donc une perte de temps pour l'examen; une mauvaise fiabilité en utilisation routinière, car un pourcentage élevé de pannes d'imageurs sont dues à des défauts de connexion de câbles; un risque de dégradation du signal surtout si le câble de liaison est long; un réglage délicat aussi bien au niveau de l'accord de la fréquence de résonance de l'antenne de réception à la fréquence du signal émis, qu'au niveau de l'adaptation de l'impédance de l'ensemble constitué par l'antenne de réception et le câble de transmission vis-à-vis de l'impédance d'entrée du récepteur pour chaque examen, etc.

Il existe également un type de liaison préamplifiée entre l'antenne de réception et le récepteur. Le signal capté par l'antenne de réception est préamplifié, à l'aide d'un amplificateur connecté à proximité de l'antenne de réception, avant sa transmission vers le récepteur via un câble coaxial souple. Toutefois, la liaison préamplifiée nécessite: des composants amagnétiques ou très faiblement magnétiques suivant la distance de l'amplificateur au volume examiné; un logement pour l'amplificateur dans le champ magnétique; un dispositif de réglage d'accord de fréquence et d'adaptation d'impédance entre l'antenne de réception et l'amplificateur; et un coût élevé si chaque antenne de réception comporte son amplificateur, puisque souvent un examen nécessite une antenne de réception spécifique. L'utilisation par exemple d'un amplificateur à haute impédance d'entrée permet de supprimer le réglage d'adaptation d'impédance qui est nécessaire pour la liaison directe par câble.

Des essais in vivo de spectroscopie à résonance magnétique nucléaire ont révélé un autre type de liaison dit "sans fil" entre l'antenne de réception et le récepteur. On peut se référer à ce sujet aux deux articles récemment parus dans la revue "Journal of Magnetic Resonance", l'un dans le volume 65, page 100 - 109 (1985) au nom de M. DECORPS et al, et l'autre dans le volume 68, page 161 - 167 (1986) au nom de M. D. SCHNALL et al. Les essais de M;D; SCHNALL consistent à introduire une antenne de réception de petite taille à l'intérieur du corps d'un animal placé dans un champ magnétique, et à poser une antenne de couplage à l'extérieur du corps de l'animal et reliée au récepteur. Les antenne de réception et de couplage sont sans contact l'une de l'autre et la transmission du signal se fait par couplage inductif entre les deux antennes. M. DECORPS a montré les avantages de ce type de liaison du point de vue de fonctionnement électrique de l'antenne de réception par rapport aux liaisons directes par câble ou préamplifiée.

Il est donc possible, grâce à ce type particulier de liaison, d'examiner très localement un organe ou une zone précise à l'intérieur du corps d'un animal. Cependant les liaisons sans fil montrées dans la littérature n'ont pour souci particulier que de faire un examen local à l'intérieur du corps ou d'améliorer l'équilibre électrique de l'antenne de réception. L'antenne de couplage doit être spécialement conçue pour s'adapter aux caractéristiques d'une antenne de réception spécifique. Un changement de l'antenne de réception entraîne le changement de l'antenne de couplage. En outre, ces liaisons sans fil doivent être minutieusement réglées pour chaque examen spécifique aussi bien au niveau de l'accord de fréquence de résonance de l'antenne de réception qu'au niveau de l'adaptation des impédances pour assurer une transmission optimale de puissance au récepteur.

L'objet de la présente invention est de pallier les inconvénients mentionnés ci-dessus des techniques classiques en réalisant un dispositif de réception à couplage inductif et sans fil destiné à équiper des appareils d'imagerie par résonance magnétique nucléaire et ne nécessitant pas un réglage particulier aussi bien au niveau d'accord de fréquence qu'au niveau de l'adaptation d'impédance de transmission pour chaque examen spécifique.

Un autre objet de l'invention est de réaliser un dispositif de réception capable de fonctionner avec des antennes de réception différentes sans nécessiter une modification du dispositif, ce qui permet un large éventail d'utilisations du dispositif pour des examens différents contrairement aux techniques classiques.

L'invention a également pour objet de simplifier la tâche de l'opérateur en le libérant des manipulations systématiques de préréglage du dispositif de réception avant chaque examen, ce qui permet d'une part de reduire la durée total de l'examen du sujet, et d'autre part de supprimer une source d'erreur de connexion par des câbles de transmission classiques.

L'objectif de l'invention est atteint par la réalisation d'un dispositif de réception comprenant en combinaison une antenne de réception, une antenne de couplage et un amplificateur à haute impédance d'entrée. L'antenne de couplage est couplée à l'antenne de réception par induction et comprend une capacité de sorbe aux bornes de laquelle sont reliées les entrées de l'amplificateur. La sortie de l'amplificateur est reliée à une unité de traitement du signal ou récepteur.

Selon un mode particulier de réalisation de l'invention, l'antenne de couplage comprend une antenne relais couplée par induction à l'antenne de réception et un transformateur d'impédance dont le primaire est en série avec l'antenne relais et dont le secondaire est en série avec la capacité de sortie. Le transformateur d'impédance peut être constitué par une bobine toroïdale à flux fermé pour éliminer tout parasite de couplage électrique et électromagnétique avec le milieu extérieur.

Selon un autre mode particulier de réalisation de l'invention, l'antenne de couplage comprend une antenne relais couplée par induction à l'antenne de réception et une bobine toroïdale à flux fermé en série avec l'antenne relais et avec la capacité de sortie.

L'ensemble des composants du dispositif de réception doit être disposé et choisi de façon à obtenir une bande de fréquence de fonctionnement assez large sur laquelle les caractéristiques du dispositif concernant notamment le facteur du bruit du dispositif et le gain en tension du signal restent sensiblement constants.

L'invention sera mieux comprise à l'étude de la description détaillée de quelques modes de réalisation de l'invention pris à titre nullement limitatif et illustrés par les dessins annexés, sur lesquels:

la figure 1 est un schéma électrique du dispositif de réception classique du type à liaison directe par câble;

la figure 2 est un schéma électrique du dispositif de réception classique du type à liaison préamplifiée;

la figure 3 est un schéma électrique du dispositif de réception classique du type à couplage inductif sans fil;

la figure 4 est un schéma électrique représentant le dispositif de réception selon un premier mode de réalisation de l'invention;

la figue 5 est un schéma électrique du dispositif de réception selon un second mode de réalisation de l'invention;

la figure 6 est un schéma électrique du dispositif de réception selon un troisième mode de réalisation de l'invention; et

la figure 7 représente deux diagrammes comparatifs du gain en tension de signal entre les modes de réalisation classiques et l'invention.

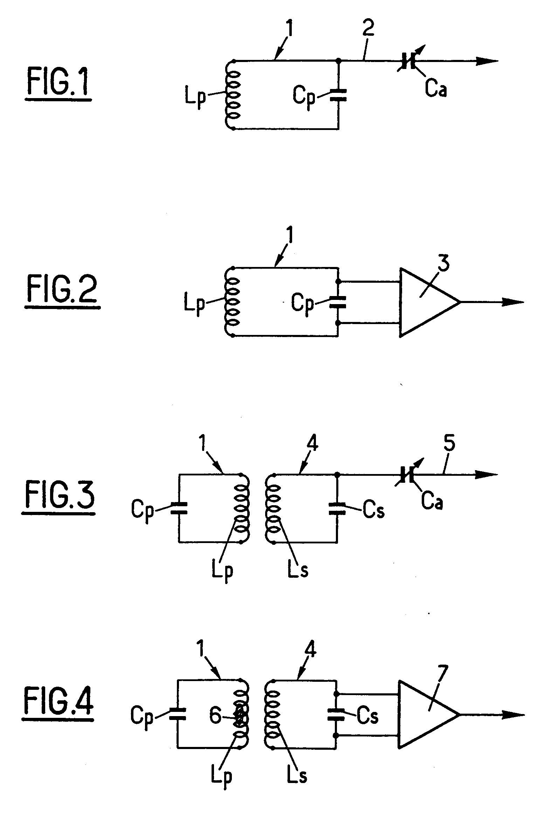

Telle qu'elle est illustrée sur la figure 1, l'antenne de réception 1 est représentée par un circuit électrique fermé comportant, une bobine de self inductance Lp en série avec une capacité Cp. L'antenne 1 est reliée par un câble 2 à une unité de traitement du signal ou un récepteur non représenté. Le câble 2 comporte une capacité d'adaptation Ca de l'impédance entre l'antenne de réception 1 et le récepteur.

Dans la pratique, l'antenne de réception 1 est disposée au voisinage immediat du volume examiné du sujet placé dans le champ magnétique pour détecter des signaux de champ magnétique émis par le volume examiné. Pour obtenir une bonne réception du signal, on règle la capacité Cp de l'antenne de réception 1 pour rendre en résonance à la fréquence du signal. En outre, la transmission du signal capté par le câble de liaison 2 doit subir le minimum de perte de puissance possible. Il est alors nécessaire de régler la capacité d'adaptation Ca pour adapter l'impédance de l'antenne de réception 1 qui varie d'un examen à l'autre, à l'impédance d'entrée du récepteur. En effet, le sujet se trouvant dans le champ magnétique présente des propriétés diélectriques qui influencent et font varier les caractéristiques électriques de l'antenne de réception 1. Si le sujet à examiner change ou si l'emplacement de l'antenne de réception 1 par rapport au sujet change, les caractéristiques de l'antenne de réception changent. Dans les appareils d'imagerie actuellement commercialisés, le réglage de capacités Cp et Ca est assuré au moyen d'un moteur pas à pas contrôlé par l'opérateur avant l'examen d'un sujet.

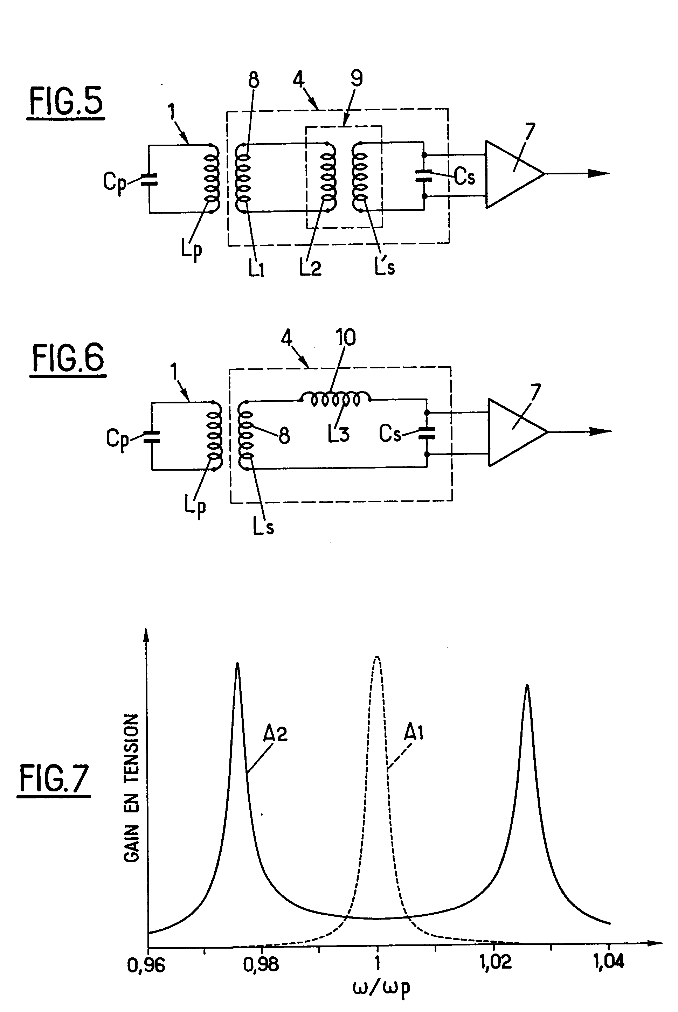

Le gain en tension du signal d'un tel dispositif de réception en fonction de la fréquence est représenté par la courbe A1 en pointillés sur la figure 7. On peut observer que la courbe du gain en tension comporte un pic de résonance lorsque la fréquence de résonance $\omega p$ de l'antenne de réception 1 est égale à la fréquence du signal $\omega$. La largeur de pic de résonance étant faible, il est donc nécessaire, pour chaque examen, de régler la fréquence de résonance de l'antenne de réception $\omega p$, appelée également le réglage de l'accord de fréquence, de façon à déplacer le pic de résonance de la courbe A1 le long des abscisses et centrer le pic sur la fréquence du signal $\omega$ émis par le volume examiné du sujet. Par ailleurs, il est nécessaire de régler également l'impédance de l'antenne de réception et le câble de transmission du signal à l'entrée du récepteur, appelé également réglage de l'adaptation d'impédance, de façon à obtenir le maximum de gain possible sur le pic de résonance.

Le dispositif de réception à liaison préamplifiée, dont le principe est illustré sur la figure 2, permet de supprimer l'étape de réglage de l'adaptation d'impédance grâce à l'amplificateur à haute impédance d'entrée 3. Mais ce montage classique nécessite toujours un câble de connexion entre l'antenne de réception 1 et le récepteur non représenté. Comparé avec la courbe A1 sur la figure 7, ce type de dispositifs présente une courbe de réponse dont le pic de résonance est deux fois plus important que celui de A1 tandis que sa largeur est deux fois moindre. Le réglage de l'accord de fréquence devient alors encore plus délicat afin de pouvoir centrer le pic de résonance sur la fréquence du signal.

Il en est de même pour des dispositifs de réception à couplage inductif classique. En effet, la conception communément adoptée jusqu'à présent pour une bonne réception du signal est basée sur le pic de résonance de la courbe du gain en tension du signal. Le réglage classique aussi bien de l'accord de fréquence que de l'adaptation d'impédance du dispositif de réception a pour but de placer le point de fonctionnement du dispositif le plus près possible du sommet du pic de résonance.

Comme on peut le voir sur la figure 3, le dispositif de réception à couplage inductif classique comporte une antenne de réception 1 couplée par induction à une antenne de couplage 4 représentée par un circuit électrique muni d'une bobine de self induction Ls en série avec une capacité Cs. L'antenne de couplage 4 est reliée par un câble de connexion 5 à une unité de traitement du signal non représentée. Une capacité Ca d'adaptation d'impédance est connectée au câble 5.

Lors de chaque examen, il est nécessaire de régler d'abord la capacité Cp ou Cs pour accorder le pic de résonance du système sur la fréquence $\omega$ du signal émis, puis la capacité Ca pour adapter l'impédance de l'ensemble vis-à-vis de l'impédance d'entrée de l'unité de traitement du signal.

La présente invention va à l'encontre du principe du dispositif de réception classique en abandonnant le pic de résonance comme point de fonctionnement optimal pour la réception du signal. En effet, l'inconvénient majeur du pic de résonance est sa faible largeur qui correspond à une bande de fréquence très étroite dans laquelle il faut régler les dispositifs de réception, d'où réglage délicat et nécessaire du dispositif avant chaque examen.

La demanderesse a observé qu'avec le type de liaison sans fil par couplage inductif, il est possible de créer une bande de fréquence dans laquelle la courbe de gain en tension du signal présente une portion sensiblement plate. Autrement dit, il est possible d'avoir une bande de fréquence assez large sur laquelle le gain en tension du signal demeure sensiblement constant. Cela a pour conséquence directe de rendre inutiles les réglages de l'accord de fréquence et de l'adaptation d'impédance avant chaque examen, puisqu'un léger écart de fréquence de résonance par rapport à la fréquence du signal est presque sans influence sur le signal transmis à l'unité de traitement du signal, alors qu'un tel écart de fréquence sort facilement du pic de résonance des dispositifs classiques, et est donc intolérable par ces dispositifs.

Cette comparaison de principe est illustrée sur la figure 7 entre la courbe A1 et la courbe A2. Comme déjà décrit, la courbe A1 représente le gain en tension du signal en fonction du rapport entre la fréquence du signal $\omega$ et la fréquence de résonance $\omega p$ de l'antenne de réception ( $\omega/\omega p$ ). Le pic unique de résonance de la courbe A1 est obtenu lorsque la fréquence de résonance de l'antenne de réception de l'antenne de reception $\omega p$ est égale à la fréquence du signal $\omega$. L'amplitude de la courbe A1 chute rapidement lorsque $\omega p$ est différent de $\omega$. En revanche, la courbe A2 caractéristique du gain en tension du signal selon la présente invention présente deux pics de résonance situés de part et d'autre, de façon sensiblement symétrique, de la valeur 1 qui correspond à une fréquence de résonance $\omega p$ égale à la fréquence du signal $\omega$. Les deux pics de la courbe A2 sont reliés par une portion de courbe sensiblement plate horizontale de faible amplitude. L'étendue de cette portion sensiblement plate de la courbe A2 est beaucoup plus importante que la largeur du pic de résonance de la courbe A1, ce qui se traduit par une largeur de bande de fréquence plus importante au voisinage du point où la fréquence de résonance $\omega p$ est égale à la fréquence du signal $\omega$.

Concrètement, la technique utilisée pour le dispositif de réception à couplage inductif classique consiste à régler le coefficient de couplage k entre l'antenne de réception 1 et l'antenne de couplage 4 de façon à le rendre proche ou égal au coefficient de couplage critique kc des deux antennes défini par les facteurs de qualité respectifs des deux antennes en présence du sujet et de l'mplificateur 3 par exemple. Le résultat se traduit par le pic unique de résonance de la courbe A1 pour la fréquence de résonance ωp égale à la fréquence du signal ω.

Selon la présente invention, le coefficient de couplage magnétique k est rendu très supérieur au coefficient de couplage critique kc en présence d'un amplificateur, ce qui a pour effet un double pic de résonance sur la courbe A2 de gain en tension du signal. On constate que plus le coefficient de couplage k est grand, plus l'écartement entre les deux pics de la courbe A2 est grand et plus l'amplitude de la portion sensiblement plate de la courbe A2 située entre les deux pics est faible.

Cependant un gain trop faible en tension du signal implique un trop faible signal fourni à l'unité de traitement du signal, et par voie de conséquence une mauvaise qualité de l'image obtenue. Il est donc nécessaire d'augmenter le gain en tension par un moyen approprié, par exemple au moyen d'un amplificateur à haute impédance d'entrée.

Le schéma électrique d'un premier mode de réalisation de l'invention est illustré sur la figure 4. L'antenne de réception 1 est couplée par induction à l'antenne de couplage 4 avec un coefficient de couplage k. Le volume examiné du sujet est représenté par la référence 6. Un amplificateur à haute impédance d'entrée 7 est relié à l'antenne de couplage 4 en parallèle de la capacité Cs, appelée capacité de sortie. La sorbe de l'amplificateur 7 est reliée à l'entrée de l'unité de traitement du signal non représentée.

Pour que le dispositif de réception de l'invention fonctionne de façon correcte, il faut remplir un certain nombre de conditions : un facteur de bruit de l'antenne de couplage négligeable par rapport au facteur de bruit de l'antenne de réception; un gain en tension du signal sensiblement constant pour une bande de fréquence aussi large que possible entre les deux pics de résonance de la courbe A2; un courant induit dans l'antenne de couplage aussi faible que possible pour éviter de créer une déformation du champ magnétique radiofréquence de l'antenne de réception; et un facteur de bruit de l'amplificateur à haute impédance d'entrée aussi faible que possible.

Il a été dit précédemment qu'une augmentation du coefficiant de couplage k entre l'antenne de réception 1 et l'antenne de couplage 4 implique un élargissement de la bande de fréquence dans laquelle la courbe A2 de gain en tension du signal est sensiblement plate. Des calculs élaborés par la demanderesse ont également montré que le facteur de bruit de l'antenne de couplage et l'intensité du courant induit dans l'antenne de couplage diminuent lorsque le coefficient de couplage k augmente. Or, les calculs ont également montré que le facteur de bruit de l'amplificateur 7 est une fonction croissante de l'inductance Lsω de l'antenne de couplage 4 et une fonction décroissante du coefficient de couplage k et du facteur de qualité de l'antenne de réception 1. Autrement dit, la minimisation du facteur de bruit de l'amplificateur 7 nécessite une augmentation de l'inductance Lsω. ou une diminution du coefficient de couplage k ou du facteur de qualité de l'antenne de réception.

Cependant, pour avoir une réception optimale et efficace du signal, le facteur de qualité de l'antenne de réception doit être maximal. Il en résulte qu'il est nécessaire de diminuer le coefficient de couplage k ou d'augmenter l'inductance Lsω de l'antenne de couplage 4 afin de minimiser le facteur de bruit de l'amplificateur à haute impédance d'entrée 7. Pour trouver une solution optimale pour le dispositif de réception de l'invention, il convient donc de chercher à augmenter au maximum la valeur de l'inductance Lsω et à trouver un compromis sur les valeurs du coefficient de couplage k, puisqu'une diminution de k entraîne une bande de fréquence plus étroite sur la courbe de gain en tension du signal A2 sur la figure 7, et une augmentation du facteur de bruit de l'antenne de couplage et de l'intensité du courant induit dans l'antenne de couplage.

En pratique, pour obtenir un bon couplage inductif entre l'antenne de réception 1 et l'antenne de couplage 4, la taille de cette dernière doit être comparable par rapport à la taille de l'antenne de réception; pour minimiser des effets de couplage électrique parasite avec l'environnement, l'inductance Lsω de l'antenne de couplage 4 doit être faible Il est donc difficile de réaliser une telle antenne de couplage par les techniques actuelles.

L'invention remédie à ce problème délicat en insérant dans l'antenne de couplage 4 une bobine inductive à flux fermé en général sous forme d'un tore qui présente une inductance très élevée et permet d'augmenter considérablement l'inductance équivalente Lsω de l'antenne de couplage 4. La bobine à flux fermé n'est pas en couplage électrique ou magnétique avec l'environnement ni avec l'antenne de réception 1. Cela permet donc de diminuer considérablement le facteur de bruit de l'amplificateur 7 à haute impédance d'entrée. Il est alors possible de régler ensuite la valeur du coefficient de couplage k entre l'antenne de réception 1 et l'antenne de couplage 4 en vue d'obtenir un compromis, par exemple en faisant varier la taille respective des antennes et la disposition relative de l'une par rapport à l'autre.

Sur la figure 5 est illustré un schéma électrique du dispositif de réception de l'invention. L'antenne de couplage 4 est constituée par une antenne relais 8 représentée par une bobine de self-inductance L1 couplée par induction avec l'antenne de réception 1, et par un transformateur d'impédance 9 dont le primaire L2 est en série avec la bobine de self-inductance L1 et dont le secondaire L's est en série avec la capacité de sortie Cs aux bornes de laquelle sont reliées les entrées de l'amplificateur 7 à haute impédance d'entrée. Il est à signaler que dans ce montage, l'antenne relais 8 constitue une masse flottante, c'est-à-dire en équilibre électrique par rapport à la masse, ce qui minimise les pertes d'origine électrique de l'antenne relais.

La figure 6 illustre un second schéma électrique du dispositif de réception de l'invention. L'antenne de couplage 4 comporte une antenne relais 8 couplée par induction à l'antenne de réception 1, et une bobine d'induction toroïdale 10 en série avec l'antenne relais 8 et la capacité Cs aux bornes de laquelle est branchée l'amplificateur 7 à haute impédance d'entrée. La bobine toroïdale 10 et à flux fermé et n'est couplée ni à l'antenne relais 8 ni à l'antenne de réception 1.

Grâce à l'invention, il est donc devenu possible désormais d'équiper des appareils d'imagerie par résonance magnétique nucléaire avec un dispositif de réception fiable, simple à utiliser et permettant de diminuer considérablement la durée totale d'un examen en supprimant les préréglages de l'accord de fréquence et de l'adaptation d'impédance.

En pratique, le dispositif de réception de l'invention peut comporter un ensemble formé par l'antenne de couplage 4 et l'amplificateur 7 à haute impédance d'entrée 7, ensemble fixé à l'intérieur de l'imageur, et une pluralité d'antennes de réception 1 appropriées pour des examens particuliers. Il suffit de choisir une antenne de réception et positionner correctement l'antenne de réception par rapport au volume examiné du sujet avant de commencer un examen.

Une autre caractéristique de l'invention consiste à obtenir une réception optimale du signal par l'antenne de réception pour contribuer encore plus à la qualité du dispositif de réception tel que décrit précédemment. La solution consiste à utiliser des matériaux supraconducteurs à haute température pour fabriquer l'antenne de réception 1. Un moyen de refroidissement, par exemple par l'azote liquide, est prévu pour rendre la résistance de l'antenne de réception aussi faible que possible afin de diminuer les dissipations d'énergie et de supprimer une source de bruit, et par voie de conséquence d'augmenter le facteur de qualité de l'antenne de réception. Une telle antenne de réception combinée avec l'antenne de couplage 4 et l'amplificateur 7 à haute impédance d'entrée contribuera à une meilleure qualité de réception du dispositif de l'invention.

Les caractéristiques du dispositif de réception, selon l'invention, dépendent dans une large mesure, du type d'examens à accomplir et des paramètres géométriques des appareils à équiper. D'une façon générale, la largeur de la bande de fréquence sur laquelle le gain en tension du signal est sensiblement constant est au moins cinq fois, voire vingt fois supérieure à la largeur du pic de résonance de fonctionnement selon les techniques classiques; le coefficient de couplage k doit être supérieur au coefficient de couplage critique kc, par exemple au moins deux fois supérieur, l'inductance équivalente $Ls\omega$ de l'antenne de couplage 4 vérifie de préférence la relation suivante :

$$Ls\omega >> Lo\omega = (k^2 QpRpVn^2)/\eta p^2$$

où k est le coefficient de couplage

Qp,Rp sont respectivement le facteur de bruit et la résistance électrique de l'antenne de réception

Vn est la tension du bruit généré par l'amplificateur à haute impédance d'entrée

$\eta p$ est la tension en série dans l'antenne de réception équivalent au bruit total induit dans l'antenne de réception.

Il en résulte que pour avoir un facteur de bruit de l'amplificateur à haute impédance d'entrée 7 faible, il faut que l'inductance $Ls\omega$ soit supérieure au moins deux fois au seuil minimum $Lo\omega$.

**Revendications**

1. Dispositif de réception de signaux électromagnétiques, notamment de signaux émis par un volume examiné d'un sujet selon la technique de résonance magnétique nucléaire, comprenant une antenne de réception (1) placée au voisinage du volume examiné et une antenne de couplage (4) couplée par induction à l'antenne de réception, caractérisé par le fait qu'il comprend en outre un amplificateur (7) à haute impédance d'entrée dont les bornes d'entrée sont reliées aux bornes d'une capacité de sortie (Cs) de l'antenne de couplage (4) et dont la sortie est reliée à une unité de traitement du signal en vue d'obtenir une image du volume examiné, et que le coefficient de couplage magnétique (k) entre l'antenne de réception et l'antenne de couplage est supérieur au coefficient de couplage critique (kc) défini par les facteurs de qualité respectifs desdites antennes en présence dudit aplificateur (7).

2. Dispositif de réception selon la revendication 1, caractérisé par le fait que l'inductance ($Ls\omega$) de l'antenne de couplage (4) doit être au moins deux fois supérieure à un seuil minimum ($Lo\omega$) en vue de diminuer le facteur de bruit de l'amplificateur (7) à haute impédance d'entrée.

3. Dispositif de réception selon la revendication 2, caractérisé par le fait que le seuil minimum ($Lo\omega$) de l'inductance de l'antenne de couplage (4) est exprimé par la relation suivante :

$$Lo\omega = (k^2 QpRpVn^2)/\eta p^2$$

où k est le coefficient de couplage;

Qp, Rp, $\eta p$ sont respectivement le facteur de qualité, la résistance électrique et la tension du bruit de l'antenne de réception (1);

Vn est la tension de bruit généré par l'amplificateur (7) à haute impédance d'entrée.

4. Dispositif de réception selon l'une des revendications précédentes, caractérisé par le fait que l'antenne de couplage (4) comprend une antenne relais (8) couplée par induction à l'antenne de réception (1), et un transformateur d'impédance à flux fermé (9) dont le primaire est en série avec l'antenne relais et dont le secondaire est en série avec la capacité de sortie (Cs).

5. Dispositif de réception selon la revendication 4, caractérisé par le fait que le transformateur d'impédance est réalisé sous forme d'une bobine d'induction toroïdale.

6. Dispositif de réception selon l'une des revendications 1 à 3, caractérisé par le fait que l'antenne de couplage (4) comprend une antenne relais (8) couplée par induction à l'antenne de réception (1), et une bobine toroïdale (10) à flux fermé en série avec l'antenne relais et avec la capacité de sortie (Cs).

7. Dispositif de réception selon l'une des revendications précédentes, caractérisé par le fait que son gain en tension du signal en fonction du rapport de la fréquence du signal sur la fréquence de résonance de l'antenne de réception ($\omega/\omega p$) présente une portion sensiblement plate comprise entre deux pics de résonance et centrée au point où la fréquence de résonance de l'antenne de réception ($\omega p$) est égale à la fréquence du signal ($\omega$).

8. Dispositif de réception selon l'une des revendications précédentes, caractérisé par le fait que l'antenne de réception (1) est réalisée à l'aide d'un matériau supraconducteur à haute température.

9. Dispositif de réception selon la revendication 8, caractérisé par le fait que l'antenne de réception comporte des moyens de refroidissement du supraconducteur.

FIG.1

FIG.2

FIG.3

FIG.4

FIG.5

FIG.6

FIG.7

GAIN EN TENSION

A2

A1

0,96    0,98    1    1,02    1,04

$\omega/\omega p$

Office européen
des brevets

# RAPPORT DE RECHERCHE EUROPEENNE

Numero de la demande

EP    91 40 1993

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | MAGNETIC RESONANCE IN MEDICINE. vol. 10, no. 3, juin 1989, DULUTH,MN US pages 302 - 309; J.R. FITZSIMMONS ET AL.: "A comparison of double-tuned surface coils" * page 304, lignes 9 - 21; figure 3 * * figure 4 * | 1, 2 | G01R33/36 |
| Y |  | 4, 7-9 |  |
| Y | SOVIET INVENTIONS ILLUSTRATED, Semaine 8826, 02 juillet 1988, abrégé no. 88-181532/26, U25, Derwent Publ. Ltd., Londres, GB. & SU-A-1356-216 (ZINOVEV A.G.), 16.07.1986 | 4 |  |
| A |  | 5, 6 |  |
| Y | US-A-4825162 (B. ROEMER ET AL.) * colonne 3, lignes 32 - 56; figures 1b, c * * colonne 5, ligne 35 - colonne 6, ligne 16; figure 5 * | 7 |  |
| Y | FR-A-2616911 (THOMSON CGR) * revendication 1 * | 8, 9 | DOMAINES TECHNIQUES RECHERCHES (Int. Cl.5) |
| A | PATENT ABSTRACTS OF JAPAN vol. 2, no. 3 (E-002) 10 janvier 1978, & JP-A-52 116053 (SHARP K.K.) 29 septembre 1977, * le document en entier * | 1, 4-6 | G01R H03H |
| A | US-A-4742304 (M.D. SCHNALL ET AL.) * colonne 10, lignes 30 - 40; figure 14A * | 1, 4-6 |  |

Le présent rapport a été établi pour toutes les revendications

| Lieu de la recherche | Date d'achèvement de la recherche | Examinateur |
|---|---|---|
| BERLIN | 06 SEPTEMBRE 1991 | MOUTARD P. |

EPO FORM 1503 03.82 (P0402)